Europäisches Patentamt

European Patent Office

Office européen des brevets

(11) Publication number: **0 151 026**
A2

# EUROPEAN PATENT APPLICATION

(21) Application number: **85300593.2**

(22) Date of filing: **29.01.85**

(51) Int. Cl.⁴: **G 01 N 24/08**

(30) Priority: **31.01.84 US 575701**

(43) Date of publication of application: **07.08.85**
**Bulletin 85/32**

(84) Designated Contracting States: **DE GB NL**

(71) Applicant: **Kabushiki Kaisha Toshiba, 72, Horikawa-cho Saiwai-ku, Kawasaki-shi Kanagawa-ken 210 (JP)**

(72) Inventor: **Hughes, Simon H.C., 36135 N. Giand Oaks Court, Gurnee Illinois 60031 (US)**

(74) Representative: **Kirk, Geoffrey Thomas et al, BATCHELLOR, KIRK & EYLES 2 Pear Tree Court Farringdon Road, London EC1R 0DS (GB)**

(54) A method for producing nuclear magnetic resonance image data.

(57) A method of producing nuclear magnetic resonance image data which represent a characteristic of a target, is described which comprises, at least, the steps of:
   a) exciting the target with a magnetic field and a radio frequency pulse;
   b) applying at least one time-varying magnetic field gradient to the target;
   c) collecting data from the target during the step of applying the at least one time varying magnetic field gradient, by acquiring a data signal from target which data signal is dependent on the values of a Fourier transform of the characteristic of the target at a plurality of sample points in the Fourier space occupied by the Fourier transform;
   d) determining the positions of the data signal sample points on a path in the Fourier space which path is defined as a constant times the integral of the time-varying gradient;
   e) interpolating the value of the data signals at a plurality of Cartesian grid points in the Fourier space using the positions and values of the data signal at the sample points in the Fourier space; and
   f) converting the value of the data signals at the Cartesian grid points in the Fourier space by Fourier transform to a spatial domain to produce the image data of the characteristic of the target.

ACTORUM AG

1

## A Method for Producing Nuclear Magnetic Resonance Image Data.

The present invention relates to a method for producing two and/or three-dimensional nuclear magnetic resonance image data, which data represent some function of the spin density distribution, the spin-lattice relaxation time ($T_1$) and the spin-spin relaxation time ($T_2$) of particular protons within a target.

Many different techniques are currently being investigated by which a characteristic image of a target can be effectively and efficiently obtained by nuclear magnetic resonance (NMR) imaging. Typically, the characteristic sought to be obtained is some function of the spin density distribution, the spin-lattice relaxation time ($T_1$) and the spin-spin relaxation time ($T_2$) of particular protons within the target. These protons are first excited by application of a magnetic field and a radio frequency (RF) pulse. Protons thus excited tend subsequently to relax, and during the process of relaxing generate a free induction decay (FID) signal. The above characteristic function of the relaxing protons within the target may be obtained by a Fourier transformation of this FID signal.

One particular nuclear magnetic resonance imaging technique, called echo-planar imaging, is disclosed in Mansfield and Pykett, Biological and Medical Imaging by NMR, 29 J. Magnetic Resonance

2

355 (1978). The _Mansfield et al._ article discloses a technique of echo-planar imaging in which a target is first subjected to a uniform magnetic field, thereby aligning protons within that target in a single direction commensurate with the direction of the uniform magnetic field. This direction may, for example, be aligned along the z-axis of the target. The _Mansfield et al._ echo-planar imaging technique simultaneously subjects the target to a linear magnetic gradient. As a result, although all protons are aligned along the z-axis of the target, the magnetic field to which the protons are subjected varies along the z-axis of the target. Thus, for any small range of z values, $n-\frac{1}{2} \leq z \leq n+\frac{1}{2}$ with appropriate units, all protons in the xy plane at $z \simeq n$ are subject to approximately the same magnitude magnetic field, whereas protons in the xy plane at $z \simeq n - 1$ and $z \simeq n + 1$ are subject to a smaller and larger magnetic field, respectively.

Next, according to _Mansfield et al._, the target is subjected to a radio frequency (RF) pulse which is tailored, that is has a specific band of frequencies, to excite protons in a single xy plane, for example the xy plane at $z \simeq n$. More specifically, to excite only these protons, the RF pulse is chosen to have a frequency spectrum corresponding to the Larmor angular frequency $(w_o)$ of the protons given by the formula $w_o = \gamma B$, where B is the magnitude of the magnetic field determined by the $z$ - coordinate, and $\gamma$ is the magnetogyric ratio of the protons under investigation.

3

At this point, the protons of the target are fully excited and begin to relax, thereby giving off an FID signal.

The Mansfield et al. echo-planar imaging technique continues by removing the linear gradient, and attempts to further influence the excited protons so that a signal representing the spin density distribution of the protons in the xy plane at $z \simeq n$ may be obtained by a one-dimensional Fourier transformation of the observed FID signal. Basically, Mansfield et al. appears to try to project the spin densities of protons lying in a discrete array in the xy plane onto a single line. Mansfield et al. promotes the use of a square-wave or a "switched gradient" along one axis and a "steady gradient" along another to achieve a condition whereby a one-dimensional Fourier transformation may be used. The actual transformation contemplated is, however, not clearly disclosed in Mansfield et al.

In Mansfield et al. the "switched gradient" is reported capable of being replaced by a cosine waveform "to good approximation," but there is no disclosure of how a suitable one-dimensional transformation can be selected if the "switched gradient" is so replaced. Mansfield et al. also asserts that a complete three-dimensional spin density distribution can be calculated in a single step, but such calculation is not disclosed.

In summary, Mansfield et al. requires the use of a "switched gradient" magnetic field to project spin-densities onto a single

4

line. However, Mansfield et al. realizes that a "switched gradient" field cannot be achieved in actual practice. Accordingly, Mansfield et al. suggests that a cosine waveform gradient can be used to good approximation of the "switched gradient". Nevertheless, Mansfield et al. appears to rely on a single line projection Fourier transformation technique suitable for the square wave "switched gradient", without considering the applicability of such technique when cosine waveform gradients are used.

A Mansfield et al. echo-planar technique is analyzed in a later publication by Tropper, Image Reconstruction for NMR Echo-Planar Technique, and for a Proposed Adaptation to Allow Continuous Data Acquisition, 42 J. Magnetic Resonance 193 (1981). Tropper considers the need to modify the Fourier transformation analysis of Mansfield et al. when cosine waveform gradients are employed. The Tropper analysis includes an explicit formulation for solving the Fourier transformation required when cosinusoidal gradients are used, but this formulation is sufficiently complex that practical application does not seem desirable.

The present invention seeks to provide an improved method for producing nuclear magnetic resonance image data.

According the present invention provides, in a first aspect, a method of producing nuclear magnetic resonance image data which represent a characteristic of a target, comprising the steps of:

5

a. exciting the target with a magnetic field and a radio frequency pulse;

b. applying at least one time-varying magnetic field gradient to the target;

c. collecting data from the target during the step of applying the at least one time varying magnetic field gradient, by acquiring a data signal from target which data signal is dependent on the values of a Fourier transform of the characteristic of the target at a plurality of sample points in the Fourier space occupied by the Fourier transform;

d. determining the positions of the data signal sample points on a path in the Fourier space which path is defined as a constant times the integral of the time-varying gradient;

e. interpolating the value of the data signals at a plurality of Cartesian grid points in the Fourier space using the positions and values of the data signal at the sample points in the Fourier space; and

f. converting the value of the data signals at the Cartesian grid points in the Fourier space by Fourier transform to a spatial domain to produce the image data of the characteristic of the target.

The first data signal can be defined as being dependent in value on the values of the Fourier transform of the characteristic plus the spatial derivative of that Fourier transform. To provide a correction factor which eliminates the effect of these spatial derivatives, an alternative method of the

0151026

6

invention provides as follows: a method of producing nuclear magnetic resonance image data which represents a characteristic of a target, comprising the steps of:

a. exciting the target with a magnetic field and a radio frequency pulse;

b. applying a first time-varying magnetic field gradient to the target;

c. collecting first data from the target during the step of applying the first time-varying magnetic field gradient by acquiring a first data signal from the target, which is dependent in value on the values of a Fourier transform plus the spatial derivative of the Fourier transform of the said characteristic of the target at a plurality of sample points in a Fourier space occupied by the Fourier tranform;

d. determining the positions of the first data signal sample points on a first path in the Fourier space which first path is defined as a constant times the integral of the first time-varying gradient;

e. interpolating the value of the first data signals at a plurality of first Cartesian grid points in the Fourier space using the positions and values of the first data signal at the first data signal sample points in the Fourier space;

f. applying a second time-varying magnetic field gradient to the target, such that second data collected from the target during application of the second time-varying magnetic field gradient lie on a second path in the Fourier space, which second path starts at the end of the first path and is identical in shape and opposite in direction to the first path;

g. collecting the second data from the target during the step of applying the second time-varying magnetic field gradient by acquiring a second data signal from the target which second data signal is dependent in value upon the values of the Fourier transform minus the spatial derivative of the Fourier transform of the said characteristic of the target at a plurality of sample points on the second path;

h. determining the positions of the second data signal sample points on the second path;

i. interpolating the value of the second data signals at a plurality of second Cartesian grid points in the Fourier space using the said positions and values of the second data signal at the second data signal sample points in the Fourier space;

j. combining the interpolated values of the first and second data signals at corresponding first and second Cartesian grid points in the Fourier space to establish combined data for each of the Cartesian grid points; and

k. converting the values of the said interpolated and combined data at the Cartesian grid points in the Fourier space by Fourier transform to a spatial domain to produce said image data of said characteristic of the target.

In an alternative aspect of the invention to the second and beforementioned aspect the invention provides a method of producing nuclear magnetic resonance image data which represents a

8

characteristic of a target, comprising the step of:

a. exciting the target with a magnetic field and a radio frequency pulse;

b. applying a first time-varying magnetic field gradient to the target;

c. collecting first data from the target during the step of applying the first time-varying magnetic field gradient by acquiring a first data signal from the target, which is dependent in value on the values of a Fourier transform plus the spatial derivative of the Fourier transform of the said characteristic of the target at a plurality of sample points in a Fourier space occupied by the Fourier tranform;

d. determining the positions of the first data signal sample points on a first path in the Fourier space which first path is defined as a constant times the integral of the first time-varying gradient;

e. applying a second time-varying magnetic field gradient to the target, such that second data collected from the target during application of the second time-varying magnetic field gradient lie on a second path in the Fourier space, which second path starts at the end of the first path and is identical in shape and opposite in direction to the first path;

f. collecting the second data from the target during the step of applying the second time-varying magnetic field gradient by acquiring a second data signal from the target which second data signal is dependent in value upon the values of the Fourier

9

transform minus the spatial derivative of the Fourier transform of the said characteristic of the target at a plurality of sample points on the second path;

g. determining the positions of the second data signal sample points on the second path;

h. combining the values of the first and second data signals at corresponding positions along the first and second paths to establish combined data for each of the said positions;

i. interpolating the value of the combined data at a plurality of second Cartesian grid points in the Fourier space; and

j. converting the values of the interpolated and combined data at the Cartesian grid points in the Fourier space by Fourier transform to a spatial domain to produce the image data of the said characteristic of the target.

For either of these latter two aspects of the invention, it is preferable that the first and second time-varying magnetic field gradients applied to the target are sinusoidal. Specific gradient configurations are disclosed.

A still further error correction is affected by the method of the present invention including application of third and fourth time-variable magnetic fields.

Finally, the steps of collecting the first and second data preferably include the substeps of: (a) receiving first and second magnetic signals from the target with a coil; and (b) demodulating these first and second magnetic signals with at least one product detector and at least one low-pass filter to produce the first and second data signals, respectively. It is understood that there are several methods of achieving the process outlined in (b), the choice being made as appropriate.

Preferred embodiments of the present invention will now be described with reference to the accompanying drawings wherein:

Figure 1 diagrammatically illustrates the location of a target within magnetic field generating coils;

Figure 2(a) illustrates the value of a static magnetic field along the z-axis used in accordance with the teachings of the preferred embodiment of the present invention;

Figure 2(b) illustrates the value of a static magnetic field plus a z-gradient magnetic field along the z-axis used in accordance with the teachings of the preferred embodiment of the present invention;

Figure 3(a) is a diagram showing the magnetic field gradient of Figure 2(b) as a function of time;

Figure 3(b) is a diagram showing a tailored radio frequency pulse used in connection with the preferred embodiment of the invention;

Figure 4 is a schematic system diagram of a preferred embodiment of the subject invention;

Figure 5 shows a target in the yz plane and the location of a thin slice;

Figure 6 illustrates z-gradient coils;

Figure 7 illustrates one possible location of an RF coil along the z-axis;

11

Figure 8 is a diagram showing magnetic field gradients structured in accordance with the teachings of the preferred embodiment of the invention;

Figure 9 illustrates a first path in an XY plane of Fourier space using the teachings of the preferred embodiment of the invention including the preparation period and the first data post period;

Figure 10 illustrates a second path in an XY plane of Fourier space using the teachings of the preferred embodiment of the invention;

Figure 11 illustrates a third path in an XY plane of Fourier space using the teachings of the preferred embodiment of the invention;

Figure 12 illustrates a fourth path in an XY plane of Fourier space using the teachings of the preferred embodiment of the invention;

Figure 13 illustrates x-gradient coils;

Figure 14 illustrates y-gradient coils;

Figure 15 is a data processing diagram illustrating the teachings of the preferred embodiment of the invention with no $T_2$ corrections;

Figure 16 is a data processing diagram illustrating the teachings of the preferred embodiment of the invention with $T_2$ corrections; and

Figure 17 illustrates a process of interpolating an FID signal to Cartesian grid points in Fourier space in accordance with

12

the teachings of the preferred embodiment of the present invention.

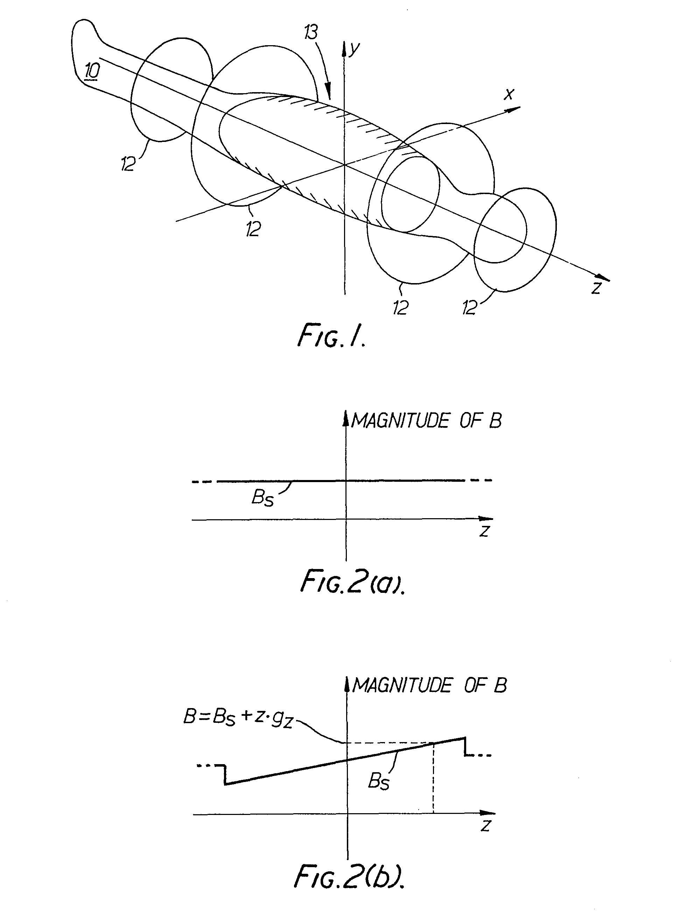

In broad terms, the present invention relates to a method for producing nuclear magnetic resonance image data which represents a characteristic of a target volume, target volume 13 in Figure 1. For example, the target might be part of a patient which, for illustrative purposes, is represented by 10 in Figure 1.

13

The first step of the subject invention requires the exciting of a target with a magnetic field and radio frequency pulse. As used herein, the term "exciting" includes subjecting the target to a uniform static magnetic field $B_s$, thereby aligning protons within the target in a single direction. This aspect of the step of "exciting" the target may, for example, be achieved by placing the target within electromagnetic coils. In this regard, in Fig. 1 electromagnetic coils 12 are illustrated surrounding target 13. Electromagnetic coils 12 are constructed as is well-known by those skilled in the art to generate a static magnetic field $B_s$ whose direction is along the z-axis and whose magnitude is uniform over the entire volume of target 13.

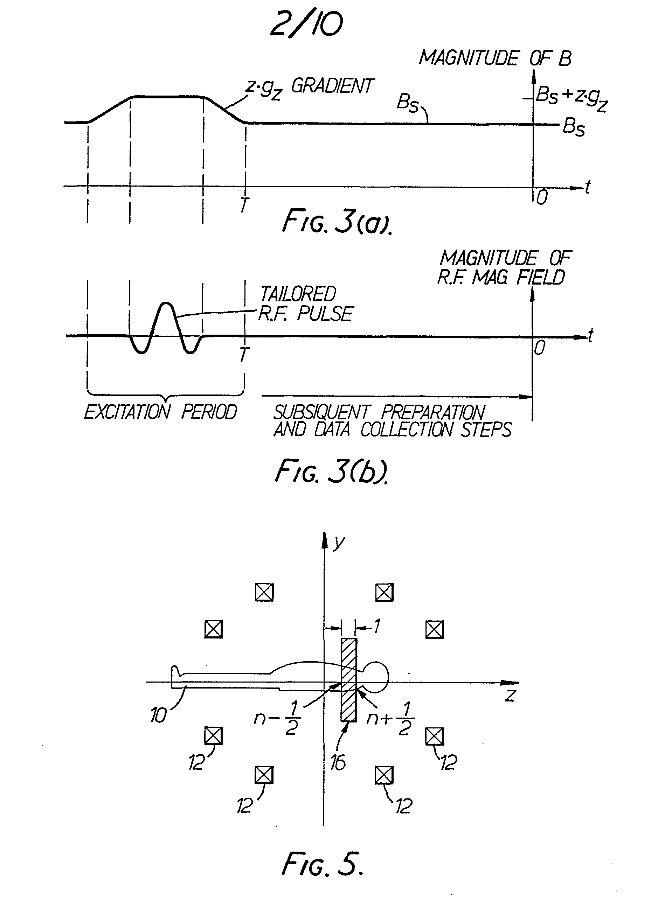

Field $B_s$ is shown in Fig. 2(a) as being uniform along the central part of the z-axis, and is shown in Fig. 3(a), which is a time diagram, as being present during the excitation period. In fact, as shown in Fig. 3(a), $B_s$ is present throughout the subsequent preparation and data collection steps.

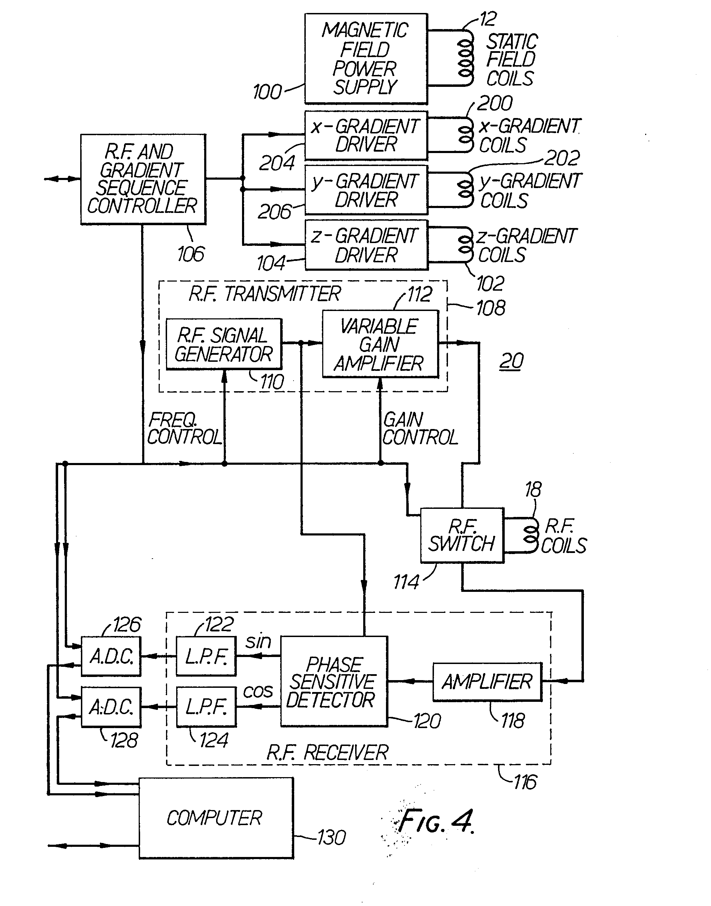

A suitable magnetic field power supply is required for the coils to generate $B_s$. In this regard, static magnetic field power supply 100 is shown in Fig. 4 coupled to coils 12.

The step of "exciting" the target contemplated by the subject invention further includes any one of several pulse sequences, all well-known to those skilled in the art. Such sequences have the common objective of causing the target, after

14

excitation, to emit an RF signal proportional to some function (characteristic) of the proton spin density, the spin-lattice relaxation time $(T_1)$, and the spin-spin relaxation time $(T_2)$ of the target. Whatever the sequence utilized, it is assumed, as is the usual practice, that at the end of the "excitation" process, all the nuclear spins in a particular volume (slice) of the target are coherently aligned perpendicular to the z-axis direction of the static field $B_s$.

For the purpose of illustrating a two-dimensional implementation of the subject invention, it is further assumed that the step of "excitation" includes some form of "slice" selection. However, it should be understood that the teachings of this invention can also be applied to three-dimensional implementation.

One illustrative example of the step of "exciting" target 13, includes subjecting the target to a linear magnetic field gradient $z \cdot g_z$ along the z-axis. Magnetic field $z \cdot g_z$ is uniform for any given xy plane, but varies linearly from xy plane to xy plane as a function of z. Gradient $z \cdot g_z$ is shown in Fig. 2(b). The time duration of gradient $z \cdot g_z$ is shown in Fig. 3(a) to exist only during the excitation period. As a result of $z \cdot g_z$, the magnitude of the magnetic field to which protons within the target are subjected $(B_s + z \cdot g_z)$, varies along one axis of the target, in this case the z-axis. Thus, for any small range of values of z, say $z \simeq n$, all protons in the xy plane at $z \simeq n$ are subject to approximately the same magnetic field, while protons in the xy plane at $z \simeq n - 1$ and $z \simeq n + 1$ are subject to a smaller and larger magnetic field, respectively.

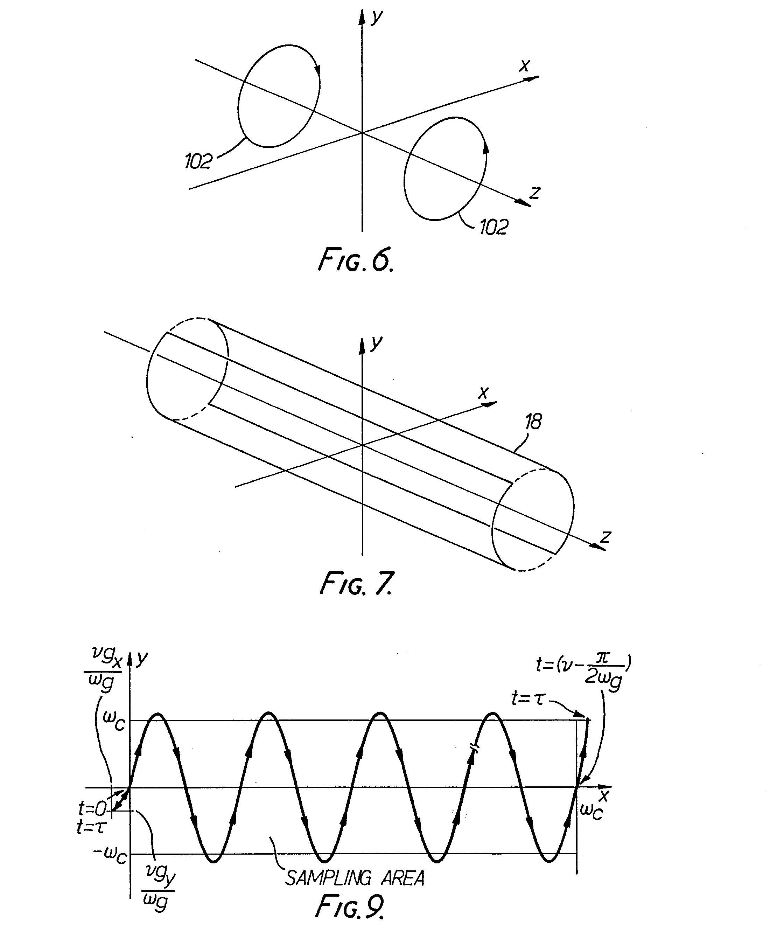

This phenomenon is generally illustrated in Figure 5, wherein planar slice 16 within target 13 is defined by the application of the $z \cdot g_z$ gradient along the z-axis. The gradient may be applied to target 13 by z-axis gradient coils 102, shown in Fig. 6. Coils 102 are excited by z-axis gradient field driver 104, and sequence controller 106 (Fig. 4). The combined effect of $B_s$ and $z \cdot g_z$ produces the total z-axis magnetic field $B(z) = B_s + z \cdot g_z$ (Fig. 3(a)).

The step of "exciting" further includes subjecting the target under consideration to a tailored radio frequency pulse. The term "tailored," as is well-known to those skilled in the art, contemplates the selection of a band of frequencies corresponding to the Larmor angular frequencies $(w_o)$ of the protons given by the equations $w_o = \gamma B(z)$, $z \simeq n$, where $B(z)$ is the magnitude of the z-axis mag-netic field, and $\gamma$ is the magnetogyric ratio of the protons. This tailored pulse is applied at a 90° angle to the field $B(z)$ to "knock" corresponding protons 90° out of alignment. Referring to Figs. 4 and 7, RF coils 18 and RF transmitter 108 operate to produce this RF pulse. RF transmitter 108 may, as illustrated in Fig. 4, comprise RF signal generator 110 and variable gain

16

amplifier 112. RF switch 114 stops the relatively large output of the RF transmitter 108 from being fed directly to the senstive RF receiver 116. The RF transmitter 108, RF switch 114 and RF receiver 116 are operated under the control of sequence controller 106, as will be understood by those skilled in the art.

With protons in xy planar slice 16 having a Larmor angular frequency $w_0 \simeq \gamma B_0(n)$, the pulse from coils 18 is selected to correspond to $w_0$, thereby "knocking down" protons in slice 16. The tailored pulse has a duration and spectral envelope governed by controller 106 (Figure 4) and exists during the excitation period as shown, for example, in Figure 3(b).

A target excited by such a tailored pulse would have the tendency, if left alone, to generate a free induction decay (FID) magnetic signal which is capable of being received by suitable RF coils, such as coils illustrated in Figure 7. However, in this embodiment of the invention to further prepare the target under consideration, prior to any observation of a received FID signal, there is a step of applying at least one time-varying magnetic field gradient to the target prior to the collection of any data from the target. The structure of the applied time-varying magnetic field gradient is intimately related to the manner in which received FID data signal is converted from Fourier space to the spatial domain. As is well-known, an FID signal generally is converted from Fourier space to a spatial domain to produce desired image data of a characteristic of the target. However, such prior art transforms are often unnecessarily complex or slow, or may fail to produce

17

optimum resolution. Importantly, a target which has been exposed to a time-varying magnetic field gradient, produces an FlD signal which, after suitable demodulation, may be considered as a measurement of the Fourier transform of the characteristic of the target under investigation at points lying along a path in Fourier space. In fact, a direct correlation has been found between the time-varying magnetic field gradient and this path through Fourier space upon which the sample points corresponding to the measured FID signal lie. The location of this path in Fourier space may be determined by simply multiplying the integral of the time-varying gradient by a constant.

The value of the resultant demodulated FID signal at a plurality of sample points on this path in Fourier space may be collected. The value of the data signals at these sample points in Fourier space may be interpolated to a value at a plurality of Cartesian grid points superimposed over the Fourier space through relatively simple and straightforward interpolation. Once the interpolated value of the data signals at a plurality of Cartesian

18

grid points in Fourier space is achieved, it is a relatively simple matter using standard Fourier transform techniques to convert these plurality of Cartesian grid point values back to spatial domain to produce image data of the characteristic of the target.

By determining the positions of the demodulated FID sample points in Fourier space by knowing the relationship between the time-varying magnetic field and the path in Fourier space upon which these data points lie, reconstruction of image data readily follows either for two or three-dimensional operation.

Thus, there are three fundamentally different aspects to the embodiment of the invention: excitation of a target, preparation of that target, and detection of the resultant FID signal. For explanatory purposes, the excitation period may be said to take place during the time period minus infinity to T, the preparation period from T to zero, and the detection period from zero to plus infinity, where T is a number less than zero. It is assumed then that at the end of the excitation period (negative infinity to T), all the magnetic moments corresponding to the characteristic of the target which is to be measured are in phase and aligned perpendicular to the static field direction (i.e., aligned perpendicular to the z-axis of the target).

During the detection period, the signal output $E(t)$ from RF coils 18 comprises a plurality of signals $\int E(t)$ which each arise

19

from a small volume of slice 16.  The signals $\oint E(t)$ arising from a small volume of slice 16 and present at the output of the coils 18 may be shown to be given by:

$$\oint E = (\underline{B}_1)_{xy} \; (\underline{M}(T))_{xy} \; e^{-(t-T)T_2^{-1}} \; \dot{\phi}(t) \; \sin \; (\phi(t) - \theta) \; \oint x \oint y \oint z$$

where

$(\underline{B}_1)_{xy}$     is a characteristic of the receiver coil 18;

$(\underline{M}(T))_{xy}$     is the magnitude of that component of the magnetic moment which lies in the x-y plane and represents the characteristic function which is to be measured;

$(-\infty, T)$     is the excitation period, T<0, and a value for T is given below;

$T_2$     is the spin-spin relaxation time constant; (typically 10 ms to 1000 ms for protons) for the small volume element;

$\phi(t)$     is the angle between that component of the magnetic moment to be measured which lies in the xy plane and the x axis;

$\dot{\phi}(t)$     denotes the time derivative of $\phi(t)$;

$\theta$     is a characteristic of the receiver coil 18;

$\oint x \oint y \oint z$     is the volume of the small element of the slice which causes the signal $\oint E$; and

x,y,z     denote the usual coordinates in three-dimensional space.

20

With $T_2$ assumed to be independent of $\underline{x}$, then

$$\phi(t) - \phi = \psi(t) - 2\pi\underline{x} \cdot \nu/\underline{g}$$

where

$\underline{x}$      is a vector representing position in $\mathbb{R}^3$

$\underline{g}$      is a time dependent vector representing the magnetic field gradient (typically in units of Tesla/cm or some equivalent unit)

$$\nu = \gamma/2\pi$$

$$\int g = \int_T^t g(\tau)\, d\tau$$

$$\Psi(t) = \phi(\tau) - \theta - 2\pi\nu(t-T)B_s$$

Denoting $(\underline{B}_1)_{xy}\, (\underline{M}(T))_{xy}$ BY $f(x)$, where f is to be regarded as approximation to the desired function $(\underline{M}(T))_{xy}$ then

$$E(t) = \frac{\gamma}{2i} e^{-(t-T)T_2^{-1}} \left\{ \begin{array}{l} e^{i\psi(t)} \int_{\mathbb{R}} d\underline{x}\ f(\underline{x}) \cdot (B_s + \underline{x} \cdot \underline{g}) \cdot e^{-2\pi i \underline{x} \cdot \nu/\underline{g}} \\[2em] -e^{-i\psi(t)} \int_{\mathbb{R}} d\underline{x}\ f(\underline{x}) \cdot (B_s + \underline{x} \times \underline{g}) \cdot e^{-2\pi i \underline{x} \cdot -\nu/\underline{g}} \end{array} \right.$$

and, defining F to be the Fourier transform of f, and using $\nabla$ ("del") to denote the usual differential operator, then

$$E(t) = \frac{\gamma}{2i} e^{-(t-T)T_2^{-1}} \left\{ \begin{array}{l} e^{i\psi(t)} \left[ B_s F(\nu/\underline{g}) - \frac{1}{2\pi i} \nabla F(\nu/\underline{g}) \cdot \underline{g} \right] \\[2em] -e^{-i\psi(t)} \left[ B_s F(-\nu/\underline{g}) - \frac{1}{2\pi i} \nabla F(-\nu/\underline{g}) \cdot \underline{g} \right] \end{array} \right. \tag{1}$$

21

assuming $\theta$ is independent of $\underline{x}$.  It is possible to compensate for first order spatial components of $\theta$ during the preparation period and to modify equation (1) accordingly, but it remains an objective of the receiver coil design to make both $\theta$ and $(\underline{B}_1)_{xy}$ independent of $\underline{x}$.

Demodulation and filtering of the received FID signal $E(t)$ is accomplished by RF receiver 116 of Fig. 4, in accordance with known processes.  Receiver 116 may, for example, comprise amplifier 118, phase sensitive detector 120, and low-pass filters 122, 124.  The FID signal $E(t)$ supplied from switch 114 to receiver 116, may be an RF signal in the range 1-10 MHz, modulated by the field gradients $\underline{g}$ to contain signals off-set from the carrier up to 10-50 kHz.  A frequency resolution of as little as 100 Hz may be required.

This signal is then digitized by the analog-to-digital converters 126 and 128 (Fig. 4), and stored in the memory of a computer 130.  A receiver 122 may therefore be used which is in a simple form, made up of a single analog input channel.  This digital output from converters 126, 128 must then be processed in order to develop image data corresponding to the investigated plane 16 of target 10 (Fig. 5).

·For reasons discussed below, $E(t)$ is preferably demodulated in phase sensitive detector 120 with a reference signal $R(t)$:

$$R(t) = e^{i \gamma t B_s} \qquad (2)$$

22

Low-pass filtering E(t) after such demodulation results in a demodulated signal $E_r(t)$:

$$E_r(t) = \frac{T}{2i} e^{-(t-T)T_2^{-1}} e^{i\gamma_1} \left[ B_s F(v \int \underline{g}) - (2\pi i)^{-1} \nabla F(v \int \underline{g}) \cdot \underline{g} \right] \quad (3).$$

where

$$\Psi_1 = \phi(T) - \theta + 2\pi \nu T B_s$$

The function f denotes the characteristic of the slice 16 of the target 13 which is to be measured and, by definition, F is the Fourier transform of f. The practical process of calculating Fourier transforms by means of the Fast Fourier Transform (FFT) is well-known to those skilled in the art. Thus, if it is possible to utilize equation (3) to calculate values of F from the measurements of $E_r$ then combining the use of equation (3) and the FFT will allow calculation of f from measurements of $E_r(t)$. From the point of view of processing the data, the ideal relationship between $E_r(t)$ and F would be

$$E_r(t) = F(\sqrt{} \int \underline{g})$$

Under these circumstances, measurements of $E_r(t)$ would be measurements of F and no processing to calculate values of F would be required. There are three factors in equation (3) which make this calculation complicated. They are:

23

(a)
$$\frac{\gamma}{2i} e^{i\Psi_1}$$

(b)
$$e^{-(t-T)T_2^{-1}}$$

and

(c)
$$(2\pi i)^{-1} \nabla F(\sqrt{\int g}) \cdot g$$

The quantity $\frac{\gamma}{2i} e^{i\Psi_1}$ is just a constant and its presence or absence is equivalent to introducing a phase change in F (and hence f), and multiplying F by $\gamma$. Since $\gamma$ is known, $\gamma$ can be allowed for, and since $\Psi_1$ can either be estimated and the inverse phase change $e^{-i\Psi_1}$ applied or one can use the fact that $\underline{f}(\underline{x})$ is known to be real and simply remove the phase change by replacing the estimated $f(\underline{x})$ by $|f(\underline{x})|$.

The term
$$e^{-(t-T)T_2^{-1}}$$

presents more of a problem. $T_2$ may be assumed to be sufficiently large for this term to be substantially constant over the time period of the experiment. However, a method of introducing a rough correction factor for $T_2$ will be presented below.

Removing the term
$$(2\pi i)^{-1} \nabla F(\sqrt{\int g}) \cdot g$$

24

is more difficult and is one of the factors which motivates the definition of the gradients. A gradient function $\underline{g}(t)$ is chosen so that there exists $t_1$ and $t_2$ with

$$t_1 \neq t_2$$

and such that

$$\int_T^{t_1} \underline{g}(\tau)\,d\tau = \int_T^{t_2} \underline{g}(\tau)\,d\tau$$

and

$$\underline{g}(t_2) = -\underline{g}(t_1)$$

With these constraints on $\underline{g}(t)$ it follows that:

$$E_r(t_1) = const \times \left[ B_s \; F(v\int^{t_1}\underline{g}) - (2\pi i)^{-1} \; \nabla F(v\int^{t_1}\underline{g}) \cdot \underline{g}(t_1) \right]$$

$$E_r(t_2) = const \times \left[ B_s \; F(v\int^{t_2}\underline{g}) - (2\pi i)^{-1} \; \nabla F(v\int^{t_2}\underline{g}) \cdot \underline{g}(t_2) \right]$$

$$= const \times \left[ B_s \; F(v\int^{t_1}\underline{g}) - (2\pi i)^{-1} \; \nabla F(v\int^{t_1}\underline{g}) \cdot \{-\underline{g}(t_1)\} \right]$$

where $\quad const \times = \dfrac{\gamma}{2i} \; e^{-(t-T)T_2^{-1}} \; e^{i\varphi_1}$

and hence

$$E_r(t_1) + E_r(t_2) = const \times \left[ 2B_s \; F(v\int^{t_1}\underline{g}) \right]$$

Thus, given that $\dfrac{\gamma}{2i} e^{i\varphi_1}$ is a constant for whose effect allowance can be made; that $T_2$ is sufficiently large that a $e^{-(t-T)T_2^{-1}}$ can be considered constant and that the term $\nabla F \cdot \underline{g}$ can be removed by placing suitable contraints on $t_1$, $t_2$ and $\underline{g}$, it is

25

therefore possible to estimate $F(\underline{q})$ from the pair of readings $E_r(t_1)$ and $E_r(t_2)$.

The process of slice selection during the excitation period essentially removes from consideration all points of the target outside the slice of interest and the function f will include only this slice of the target. The signal $E(t)$, then, is essentially determined by the function h where

$$h(x,y) = \int_{-\infty}^{\infty} f(x,y,z)\, dz \qquad (5)$$

and f is zero for z outside the slice.

The function $h(x,y)$ is dependent only on the variables x and y. The Fourier transform of this quantity is the function $F(X,Y,0)$, and using the FFT process to make a numerical estimate of $\int f\, dz$ from $F(X,Y,0)$ means that F must be known at the points $X = j\Delta$, $Y = k\Delta$ for a suitable integers j and k, and sample spacing $\Delta$. If the slice is to be imaged with a spatial resolution of $w_c$ then in general it will be necessary to obtain samples of F over the region $-w_c \leqslant X \leqslant w_c$, $-w_c \leqslant Y \leqslant w_c$. Since f is real, then, as is well-known to those skilled in the art,

$$F(-\underline{X}) = \overline{F(\underline{X})}$$

where $\overline{F}$ denotes the complex conjugate of F, and it is therefore sufficient to obtain values for F over any half plane, for example $0 \leqslant X \leqslant w_c$ and $-w_c \leqslant Y \leqslant w_c$.

25

26

Since the data values available for F($\underline{X}$) are obtained by a combination of sampling $E_r(t)$ for various values of t and calculating F($\underline{X}$), the values of F are only available at points determined by:

$$\underline{X}(t) = \sqrt{} \int_T^t \underline{g}(\Upsilon) \, d\Upsilon \qquad (4).$$

This equation (4) defines a path $\underline{X}(t)$ through Fourier space in terms of the parameter t and data samples for $E_r$ and, hence, values of F are available at points along the path corresponding to the particular values of t for which $E_r(t)$ is sampled.

In other words, the position of each data sample from the analog-to-digital converters 126 and 128 corresponds to a point on a path in Fourier space, which path is defined as a constant ($\sqrt{}$) multiplied by the integral of the time varying magnetic gradient applied to the target ($\int \underline{g}$).

For example, if

$$T = 0$$

and

$$\underline{g}(t) = (g_x, \, g_y \cos w_g t, \, 0)$$

where $g_x$, $g_y$ are constants, then

$$\underline{X}(t) = \sqrt{} \int_T^t \underline{g}(\Upsilon) \, d\Upsilon$$

$$= (\sqrt{} t g_x, \sqrt{} g_y w_g^{-1} \sin w_g t, \, 0)$$

is the parametric equation defining the path through Fourier space in terms of the parameter t and the non-parametric form is:

27

$$Y = \sqrt{g_y w_g^{-1}} \sin (w_g X / g_x)$$
$$Z = 0$$

Attention will now be given to specific preferred gradients in view of the foregoing discussion. In accordance with a preferred embodiment of present invention, assuming $T = -3\pi/2w_g$, it is preferable that the magnetic field gradients $\underline{g}(t)$ be defined as follows:

$$(\underline{g}(t))_x = \begin{cases} \frac{1}{2} g_x \cos \omega_g t & t \in \left[-\frac{3\tau}{2\omega_g}, -\frac{\tau}{2\omega_g}\right] \\ g_x \cos \omega_g t & t \in \left[-\frac{\tau}{2\omega_g}, 0\right] \\ g_x & t \in \left[0, \tau - \frac{\tau}{2\omega_g}\right] \\ g_x \cos \omega_g \left(t - \tau + \frac{\tau}{2\omega_g}\right) & t \in \left[\tau - \frac{\tau}{2\omega_g}, \tau\right] \end{cases}$$

$$(\underline{g}(t))_y = \begin{cases} \frac{1}{2} g_y \cos \omega_g t & t \in \left[-\frac{3\tau}{2\omega_g}, -\frac{\tau}{2\omega_g}\right] \\ g_y \cos \omega_g t & t \in \left[-\frac{\tau}{2\omega_g}, \tau\right] \end{cases}$$

$$(\underline{g}(t))_z = 0 \qquad \forall t$$

Where $(g(t))_x$ denotes the x-component of $g(t)$, etc..
The above defines $\underline{g}(t)$ for the preparation period $[T,0]$ and for the first observation period $[0,\Upsilon]$ (the assignment of $\Upsilon$ is discussed below). With this definition $\underline{g}(t)$ is integrable on $[0,\Upsilon]$. This definition is now extended to $t \in [0,4\Upsilon]$ as follows: if it is required that

$$\int_T^t \underline{g} = \begin{cases} \int_T^{2\tau - t} \underline{g} & t \in [\tau, 2\tau] \\ -\int_T^{t - 2\tau} \underline{g} & t \in [2\tau, 3\tau] \\ -\int_T^{4\tau - t} \underline{g} & t \in [3\tau, 4\tau] \end{cases}$$

28

.then one has:

$$\underline{g}(t) = \begin{cases} -\underline{g}(2_\tau - t) & t \in [\tau, 2_\tau] \\ -\underline{g}(t - 2_\tau) & t \in [2_\tau, 3_\tau] \\ \underline{g}(4_\tau - t) & t \in [3_\tau, 4_\tau] \end{cases}$$

The functions $(\underline{g}(t))_x$, $(\underline{g}(t))_y$, $(\int \underline{g})_x$ and $(\int \underline{g})_y$ are illustrated in Figs. 8(a), 8(b), 8(c), and 8(d), respectively. This completes the definition of $\underline{g}(t)$ apart from the fact that further comment is required on the choice of $g_x$, $g_y$, $w_g$ and $\Upsilon$.

However, it is far from obvious why such a definition has been chosen, and some space is therefore devoted to examining the implications of the definition given.

First of all note that

$$\underline{X}(0) = v \int_T^0 \underline{g} = \underline{0}$$

hence the curve $(X(t), Y(t), 0)$ in Fourier space, (shown in Fig. 9) starts at the origin at t=0. Further

$$\underline{X}(t) = v \int_T^t \underline{g} = v \int_0^t \underline{g}$$

$$= (v g_x t, \quad v g_y w_g^{-1} \sin w_g t, 0) \quad t \in [0, \tau]$$

so that

$$Y = v g_y w_g^{-1} \sin (w_g X / v g_x)$$

29

Now consider $t \in [\Upsilon, 2\Upsilon]$, putting $t = \Upsilon + \delta\Upsilon$ ($\delta\Upsilon \in [0, \Upsilon]$), equations (5) and (6) yield:

$$\underline{X}(\tau+\delta\tau) = \int_0^{\tau+\delta\tau}\underline{g} = \int_0^{\tau-\delta\tau}\underline{g} = \underline{X}(\tau-\delta t)$$

$$\underline{g}(\tau+\delta\tau) = -\underline{g}(\tau-\delta\tau)$$

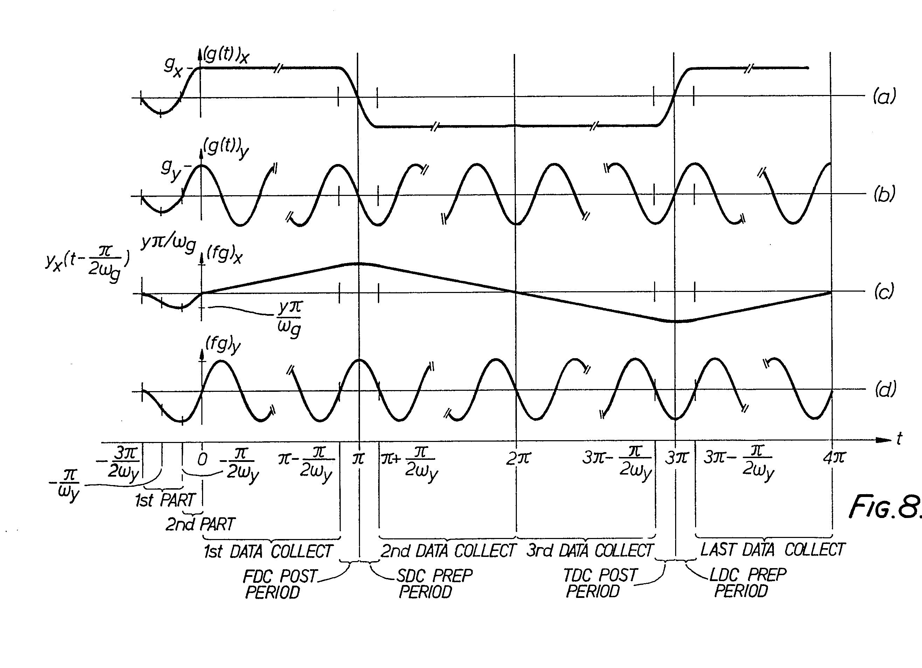

thus the position of $\underline{X}$ at $t = \Upsilon + \delta\Upsilon$ and $t = \Upsilon - \delta\Upsilon$ is identical, that is for $t \in [\Upsilon, 2\Upsilon]$ the point $\underline{X}(t)$ is moving back along its original path defining a second path through Fourier space (see, Fig. 10). Note that $\underline{g}$ has changed sign between the first and second path.

Similarly when $t \in [2\Upsilon, 3\Upsilon]$, putting $t = 2\Upsilon + \delta\Upsilon$ in equations (5) and (6) gives

$$\underline{X}(2\tau+\delta\Upsilon) = -\underline{X}(2\tau-\delta\Upsilon)$$

$$\underline{g}(2\tau+\delta\Upsilon) = \underline{g}(2\tau-\delta\Upsilon)$$

giving rise to the third path in Fourier space shown in Fig. 11.

For $t \in [3\Upsilon, 4\Upsilon]$, and $t = 3\Upsilon + \delta\Upsilon$ one has

$$\underline{X}(3\tau+\delta\Upsilon) = \underline{X}(3\tau-\delta\Upsilon)$$

$$\underline{g}(3\tau+\delta\Upsilon) = -\underline{g}(3\tau-\delta\Upsilon)$$

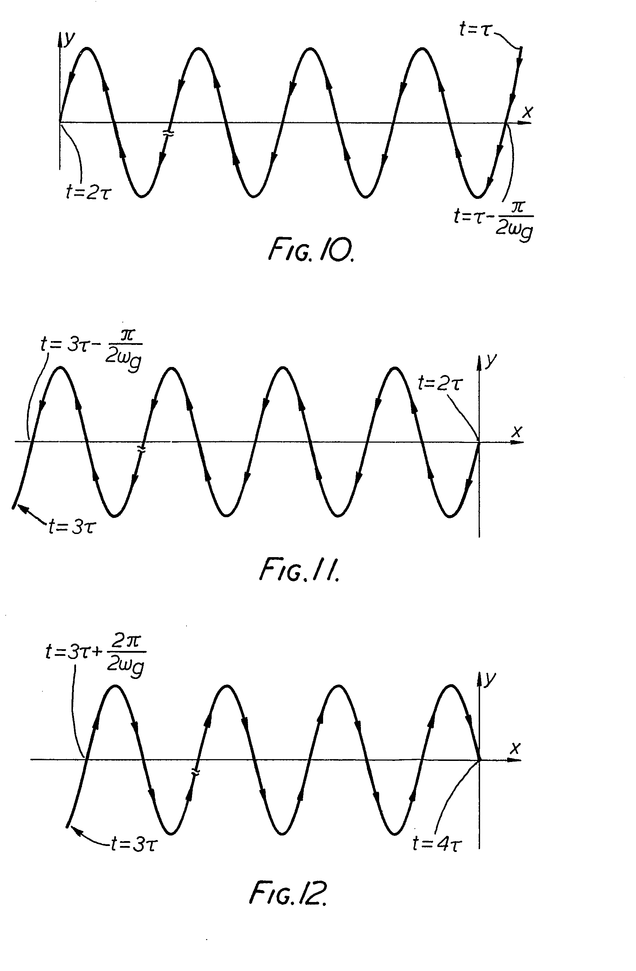

and once again $\underline{g}$ has changed sign while $\underline{X}$ is moving back along its third path to define a fourth path in Fourier space, as shown in Fig. 12.

30

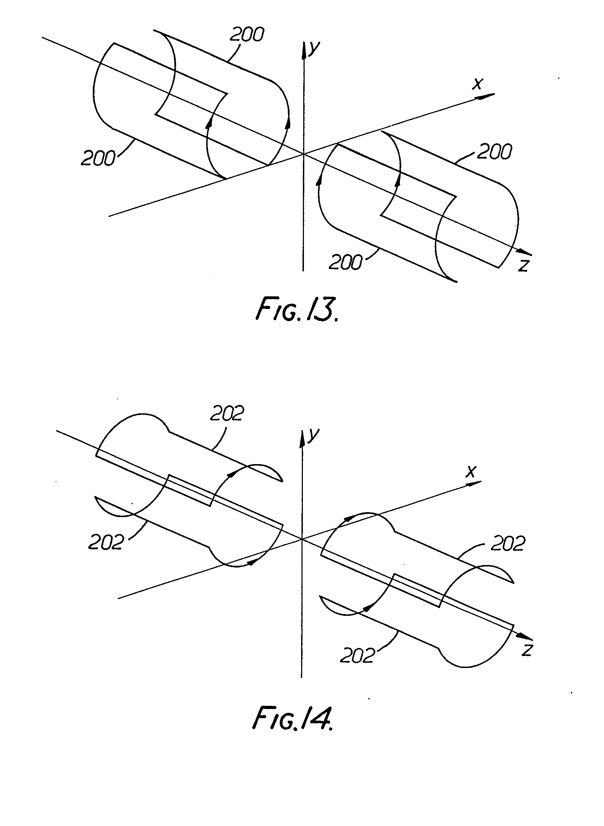

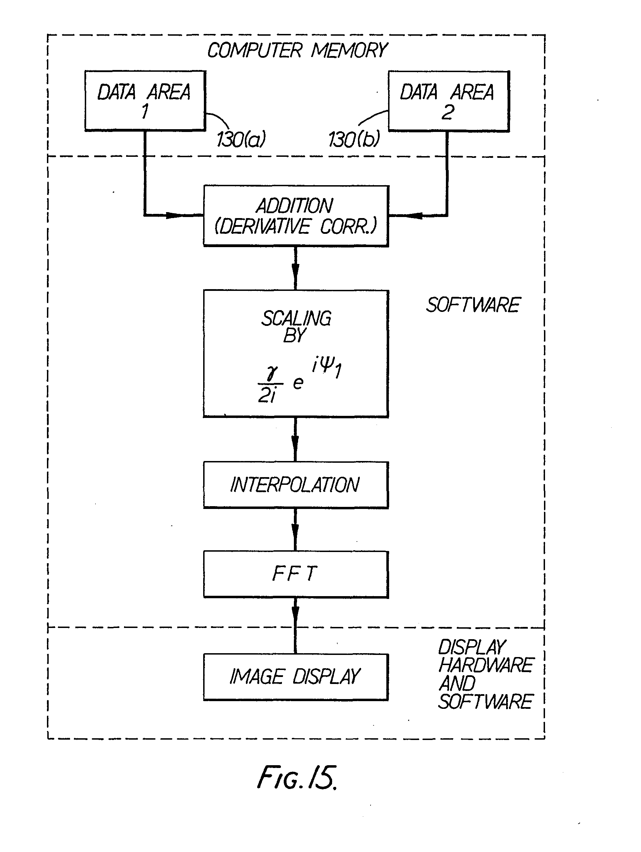

The magnetic gradients defined above may be applied to target 10 by means of x-axis gradient coils 200 drawn in Fig. 13, and y-axis gradient coils 202 shown in Fig. 14. Coils 200 are driven by an x-gradient driver 204 (Fig. 4), which is under the control of sequence controller 106. Coils 202 are driven by a y-gradient driver 206 which is also under the control of sequence controller 106.

In each instance discussed above, the path through Fourier space is limited to the XY plane. If a three dimensional path is required, the z-axis gradient may be altered in the same or similar manner as the y-axis gradient.

The First Data Collection (FDC) post period, Second Data Collection (SDC) preparatory period, Third Data Collection (TDC) post period, and Last Data Collection (LDC) preparation period of Fig. 8 allow time for $g(t)$ to change smoothly (i.e. without discontinuities) from the value required for the previous data collection period to the value required for the next data collection period.

The constant $T$ is chosen so that $(g(t))_y = 0$ at $t=T$, thus

$$T = (4n+1) \frac{\pi}{2w_g}$$

$$\text{or } T = (4n+3) \frac{\pi}{2w_g}$$

for some positive integer n. The first option is chosen because this makes the FDC period $[0, T - \pi/2w_g]$ a complete number of

31

cycles of the path $\underline{X}(t)$. This later condition ensures that $(\underline{g}(t))_y$ is continuous (in fact $(\underline{g}(t))_y = g_y \cos w_g t$ for $t \in [0, 4\Upsilon]$). Similarly the rather obscure definition of $(\underline{g}(t))_x$ for $t \cong \Upsilon$ ensures that this component has no discontinuities. This is done because it is not only impossible but also undesirable for $\underline{g}(t)$ to change too fast. This same fact provides the motivation for the definition of $\underline{g}$ on $[T, 0]$.

The remaining constants $g_x$, $g_y$, $w_g$ and n are chosen in accordance with the standard practices of sampling theory. The point $\underline{X}(2n\Upsilon/w_g)$, which is the end of the FDC period, must be chosen so that the X interval $[0, w_c]$ is covered thus:

$$X(2n\,\Upsilon/w_g) \quad = \quad \frac{\jmath\, 2n\,\Upsilon}{w_g} \cdot g_x \geqslant w_c.$$

Similarly, the amplitude of the path, $\jmath g_y/w_g$, must be chosen so that the Y intveral $[-w_c, w_c]$ is adequately covered, thus:

$$\frac{\jmath g_y}{w_g} \geqslant w_c.$$

The gradient magnitudes $g_x$ must be chosen so that the effect of inhomogeneity in the static field is reduced to acceptable levels and $w_g$ and the data sampling rate of the analog to digital converter must be chosen so that an adequate number of samples are collected for the interpolation and subsequent FFT given the slice dimensions and the spatial resolution required.

Given the desired path $\underline{X}(t) = \jmath\int_{\Upsilon}^{t}\underline{g}$ for $t \geqslant 0$ in Fourier space, the values of $\underline{g}(t)$ for $t \geqslant 0$ are now determined. The values of $\underline{g}$ for $t \leqslant 0$ are then determined by the continuity requirement $\underline{g}(0-) = \underline{g}(0+)$ and by the requirement that gradient

32

manipulation in the interval [T,0] should not affect the path $\underline{X}(t)$ for $t \geqslant 0$ thus giving $\int_T^0 \underline{g} = \underline{0}$.

Summarizing, the method includes the steps of exciting a target with a magnetic field. This step of exciting is illustratively shown by Figs. 1, 2(a), 2(b), and 3(b) as subjecting a target to a static field which includes a static uniform component $B_s$ and static gradient along the z axis, $\underline{g}(t) = (0, 0, g_z)$. The step of exciting extends during an excitation period after which the z-gradient is removed. During this excitation period as illustratively shown in Fig. 3(b) a tailored pulse is applied to excite protons within a selected xy planar slice, for example, slice 16 of Fig. 5.

The method of the subject invention further includes the step of applying at least a first varying magnetic field gradient to the target. Illustrative of this step, a time-varying magnetic field gradient $\underline{g}(t)$ as shown in Fig. 8 may be applied to target 13 of Fig. 1. In Fig. 8, a first time-variable magnetic field gradient $\underline{g}(t)$ is shown to occur during the first data collection period whereas a second time-varying magnetic field gradient is shown to apply during the second data collection period of Fig. 8. A third time-variable magnetic field gradient is illustratively shown in Fig. 8 during a third data collection period and a fourth time-variable magnetic field gradient is also disclosed in Fig. 8 for a last data collection period.

33

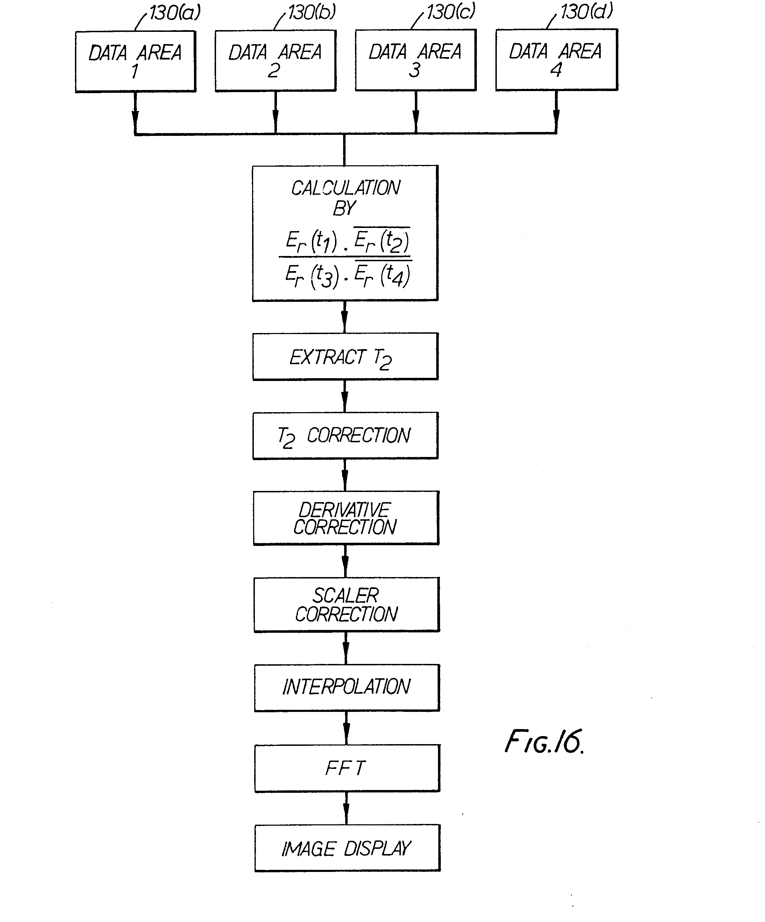

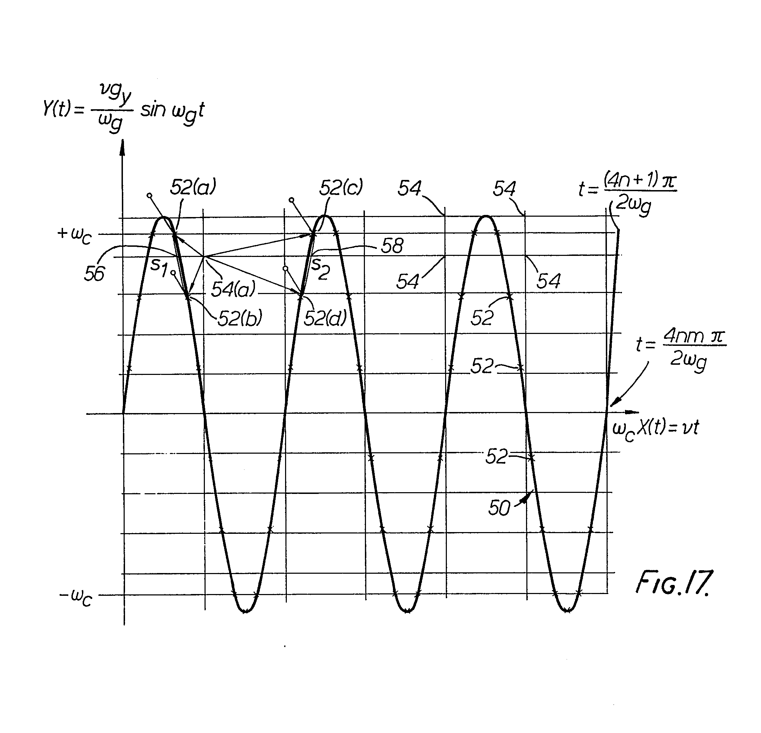

The method of the present invention includes the further step of collecting first data from the target during the step of applying the first time-varying magnetic field gradient by acquiring a first data signal from the target which first data signal is dependent in value on the values of a Fourier transform plus the spatial derivative of the Fourier transform of the characteristic of the target at a plurality of sample points in Fourier space occupied by that Fourier transform. Preferably, the step of collecting this first data includes the sub-steps of receiving a first magnetic signal from a target with a coil and then demodulating that first resultant signal with at least one product detector to produce the first data signals. As illustratively shown in Fig. 5, coils 18 are used during the first data collection period of Fig. 8 to receive a magnetic signal E(t) from target 13. Signal E(t) is demodulated with a phase sensitive detector 120 and passed through low-pass filters 122 and 124 to produce first data signals having a real part (from low-pass filter 122) and an imaginary part (from low-pass filter 124). This first data signals are sampled by analog-to-digital convertors 126 and 128, and stored in memory of computer 130 (see Figs. 15 and 16). During the second data collection period of Fig. 8, E(t) is demodulated and passed through low-pass filters 122, 124 for the second data collection period, and the resultant digital samples from convertors 126, 128 are also stored in a

34

second data area 130(b) of the memory of computer 130. In a similar manner, digital samples of $E_r(t)$ for the third data collection period of Figure 8 are sampled and stored in a third data area 130(c) of memory and digital samples of $E_r(t)$ during the last data collection period of Figure 8 are sampled and stored in a fourth data area 130(d) of memory.

The sample signals $E_r(t)$ stored in data memory areas 130a through 130d are dependent on the values of a Fourier transform of the characteristic under investigation of target 10, namely some function of the spin density distribution at the time constants $T_1$ and $T_2$ within planar slice 16 of target 13. This relationship may be seen by equation (3) set forth above. However, equation (3) indicates that $E_r(t)$, namely the demodulated and filtered $E(t)$ signal, includes a relationship which is dependent not only the Fourier transform, $B_s F(\sqrt{} \int \underline{g})$, but also on the spatial derivative of that Fourier transform (namely the term of equation (3) including $\triangledown F(\sqrt{} \int \underline{g}) \cdot \underline{g}$).

Furthermore, the subject method includes the step of determining the positions of the first data signal sample points on a first path in Fourier space, which first path is defined as a constant times the integral of the first time-varying gradient. As applied to the illustrative preferred embodiment disclosed herein, the sample points of $E_r(t)$ from the output of analog-to-digital convertors

35

126, 128 (which act as a digital sampler) lie on a path defined in Fourier space as a constant times the integral of the time-varying gradient $\underline{g}(t)$, since $\underline{X} = \sqrt{}\int \underline{g}$. Therefore, by taking the integral of the magnetic field gradient as a function of time, one can determine the precise location in Fourier space of each sample point $E_r(t)$. In this regard, attention is directed to Fig. 17 which discloses the XY coordinates of a plane in Fourier space. Path 50 winds its way through the Fourier space defined by plane XY. Path 50 has indicated on it a plurality of sample point 52. The value of path 50 at each sample points 52 can be determined by first determining at what point in time path 50 pass through a particular sample point 52. This can be determined by the relationship $\underline{X} = \sqrt{}\int \underline{g}(t)$, since $\underline{g}$ is known. Thus, once having determined the position of a particular sample point 52 in Fourier space, say for example sample point 52a, the value $E_r(t)$ may be readily determined by accessing that value of $E_r(t)$ from the first data area of computer 130 (Fig. 4) for that point in time. In a similar manner the value of path 50 through Fourier space at sample point 52b, 52c and 52d can also be determined by simply accessing the corresponding $E_r(t)$ values stored in first data area using the relationship $\underline{X} = \sqrt{}\int \underline{g}(t)$.

In a similar manner the value of $E_r(t)$ for the second, third and last data collection periods can be located on second, third and fourth paths through Fourier space illustrated in Figs. 10, 11 and 12, respectively.

36

The method disclosed herein further includes the step of interpolating the value of the first data signals as a plurality of first Cartesian grid points in the Fourier space using the positions and values of the first data signal at the first data signal sample points in the Fourier space.

A plurality of representative Cartesian grid points 54 are shown in Figure 17. It is preferable to interpolate the value of $E_r(t)$ for each of grid points 54. Although there are a number of sophisticated known processes by which such interpolation may be accomplished, one of the simplest of such methods includes the steps of selecting four sample points nearest the particular Cartesian grid point under consideration. For example, if Cartesian grid point 54a of Figure 17 was under consideration, sample points 52a, b, c and d would be selected. The step of interpolation next requires selecting the two of the sample points 52a, b, c and d which have an X value less than the X value of the chosen Cartesian grid point 54a. For the example of Figure 17, these two sample points are 52a and 52b. Next, the value of $E_r(t)$ at sample points 52a and 52b are averaged to determine a corresponding value for the point 56 having the same Y coordinate as the Cartesian grid point 54a and lying on the straight line joining 52(a) and 52(b). Calling this average value $s_1$, $s_1$ may be determined by: $s_1 = E_{r52b}(t) + E_{r52a}(t) - E_{r52b}(t)) \cdot (r_2(/r_1 + r_2))$, where $E_{r52a}(t)$ equals the value of $E_r(t)$ at sample point 52a, $E_{r52b}(t)$ equals the value of $E_r(t)$ at sample point 52b, $r_1$ equals the distance from the Y-axis coordinate of Cartesian grid point 54a to the Y-axis coordinate of the sample

37

point 52a and $r_2$ equals the distance from the Y-axis coordinate of Cartesian grid point 54a and the Y-axis coordinate of the sample point 52b.

A similar process is used to determine an average value $s_2$ of the point 58 from $E_r(t)$ at sample points 52c and 52d. Finally, using a similar methodology, the interpolated value of $E_r(t)$ for Cartesian grid point 54a is determined using the calculated values $s_1$ and $s_2$ and the respective distances between the points 56, 54a and 58.

A similar methodology may be employed to calculate the value of $E_r(t)$ for each Cartesian grid point 54 in the XY Fourier space plane of Figure 17.

Additionally the step of converting the value of each data signal at the Cartesian grid points in Fourier space by Fourier transformation to a spatial domain to produce image data of the investigated characteristic of the target, is carried out.

As applied to the interpolated values $E_r(t)$ at Cartesian grid points 54 of Figure 17, any of many well-known two-dimensional discrete Fourier transformations may be employed. This is true,

38

since the interpolated values are now located on a Cartesian coordinates system in Fourier space. For example, a Fourier transformation may be employed as set forth in A. Oppenheim & R. Schafer, Digital Signal Processing § 3.9, at 115-21 (Prentice-Hall, Inc. 1975). This material is hereby expressly incorporated by reference. Of course, more sophisticated two dimensional discrete Fourier transformation methods may be employed consistent with the spirit of the subject invention.

As noted above, $E_r(t)$, although dependent upon the values of a Fourier transform in Fourier space, are in fact dependent upon these values plus the spatial derivative of the Fourier transform (note equation 3). However, a simple combination of $E_r(t)$ for the first data collection period of Fig. 8 and for the second data collection period of Fig. 8 provides a correction eliminating these spatial derivatives. Specifically:

$$E_r(t_1) = \frac{\gamma}{2i} e^{-(t_1 - T)T_2^{-1}} \cdot e^{i\gamma_1} \left[ B_s F(v\int^{t_1} q) - (2\pi i)^{-1} \nabla F(v\int^{t_1} q) \cdot q(t_1) \right]$$

and from equations (5) and (6),

$$v\int^{t_2} q = v\int^{t_1} q \text{ and } q(t_2) = -q(t_1) \text{ thus}$$

$$E_r(t_2) = \frac{\gamma}{2i} e^{-(t_2 - T)T_2^{-1}} \cdot e^{i\gamma_1} \left[ B_s F(v\int^{t_1} q) - (2\pi i)^{-1} \nabla F(v\int^{t_1} q) \cdot -q(t_1) \right]$$

39

hence

$$E_r(t_1) + E_r(t_2) = \frac{\gamma}{2} e^{T/T_2} e^{i\Psi_1}\left[B_3 F(\nu \int \frac{t_1}{2})\right]$$

provided $2T << T_2$ (because $0 \leqslant t_1 \leqslant t_2 \leqslant 2T$) where $t_1$ is in the first data collection period, and $t_2$ is the second data collection period. From this, one may proceed to the estimation of F.

This process is shown in Fig. 15, where the real and imaginary parts of $E_r(t)$ for each data sample point stored in the first data memory area 130(a) is added to the corresponding data sample point stored in the second data memory area 130(b). This addition results in a correction which eliminates the spatial derivatives of $E_r(t)$.

The resultant sums are then each scaled by the factor $\frac{\gamma}{2\pi} e^{i\Psi_1}$. After scaling, the data points are interpolated and then Fast Fourier Transformed to produce image data suitable for display.

With this process, there still remains, however, an attenuation effect due to the assumption that $2T \ll T_2$. From equations (5) and (6) it can be shown that

40

$$\int^{t_1} \underline{q} = -\int^{t_1} \underline{q} \quad , \quad \underline{\xi}(t_1) = -\underline{\xi}(t_1)$$

$$\int^{t_1} \underline{q} = -\int^{t_1} \underline{q} \quad , \quad \underline{\xi}(t_1) = \underline{\xi}(t_1) \;.$$

Using these and the facts that:

$$F(-\underline{X}) = \overline{F(\underline{X})}$$

$$(\nabla F)(-\underline{X}) = -\overline{(\nabla F)(\underline{X})}$$

then it may be shown that:

$$\frac{E_r(t_1)\overline{E_r(t_2)}}{E_r(t_3)\overline{E_r(t_4)}} = e^{4\tau T_2^{-1}}$$

from which a value of $T_2$ may be estimated for each $t_1 \in [0, \Upsilon]$. Given $T_2$, an approximate correction can be made to the values of $E_r(t)$ to allow for $T_2$ decay.

Specifically, as shown in Fig. 16, the data sample point values $E_r(t_1)$ are multipled by corresponding values $\overline{E_r(t_2)}$ and then divided by the product $E_r(t_3) \cdot \overline{E_r(t_4)}$ for corresponding data sample points. $T_2$ is calculated using equation (7), and then used to correct the value of each data sample point in the first, second, third and fourth data memory areas 130(a), 130(b), 130(c), 130(d). The corrected data sample point values for the first and second data memory areas are then used as described

41

above with respect to Fig. 15 to produce image display data. The resultant image data not only has a correction to eliminate the negative effects of the spatial derivative of the Fourier transform in $E_r(t)$ but also has a correction to reduce the negative effect of the underlying assumption that $T_2$ is very much greater than the time during which data collection occurs. Further it is also possible to obtain a record estimate of F by calculating the quantity $\overline{E_r(t_3) + E_r(t_4)}$ from the third and fourth memories 130(c) and 130(d). These two estimates of F could then be combined to further improve the accuracy of F if this was felt desirable.

Data collected during the first, second, third and fourth data collection periods may, of course, be combined either before or after interpolation to Cartesian grid points.

The above-described embodiment of the present invention describes how image data may be obtained directly from a two-dimensional planar slice 16 of a target 13. It should be understood that the principles of the subject invention are also applicable to three-dimensional imaging. For example, multiple slices 16 may be taken in succession through target 13 using the techniques described above. In the alternative, slice 16 may be chosen to have depth either by minimizing the graduation of z-gradient $zg_z$, or by widening the frequency spectrum of the tailored pulse applied by RF transmitter 108. Once a slice 16 of

42

significant height is employed, then during data collection the amplitudes of the x, y, and z gradients may be varied to define a three-dimensional path through Fourier space. The location of the resultants sample points of the signal $E_r(t)$ may be determined using the integal of the three-dimensionally varying magnetic gradients, to interpolate those values $E_r(t)$ to three-dimensional Cartesian grid points in the Fourier space. Three-dimensional discrete Fourier transform technology may then be used to convert the interpolated $E_r(t)$ values to the spatial domain.

It is also possible to achieve three-dimensional imaging by using the subject methodology to achieve imaging of a two-dimensional projections and then using standard back-projection reconstruction methodology to extend into three-dimensional space. -

43

CLAIMS:

1.       A method of producing nuclear magnetic resonance image data which represent a characteristic of a target, comprising the steps of:

      a. exciting the target with a magnetic field and a radio frequency pulse;

      b. applying at least one time-varying magnetic field gradient to the target;

      c. collecting data from the target during the step of applying the at least one time varying magnetic field gradient, by acquiring a data signal from target which data signal is dependent on the values of a Fourier transform of the characteristic of the target at a plurality of sample points in the Fourier space occupied by the Fourier transform;

      d. determining the positions of the data signal sample points on a path in the Fourier space which path is defined as a constant times the integral of the time-varying gradient;

      e. interpolating the value of the data signals at a plurality of Cartesian grid points in the Fourier space using the positions and values of the data signal at the sample points in the Fourier space; and

      f. converting the value of the data signals at the Cartesian grid points in the Fourier space by Fourier transform to a

44

spatial domain to produce the image data of the characteristic of the target.

2. A method of producing nuclear magnetic resonance image data as claimed in claim 1, wherein the step of applying the time-varying magnetic field gradient includes a preparatory phase wherein the time-varying magnetic field gradient is structured to cause the said path in Fourier space to pass through an origin point in the Fourier space at a preselected time.

3. A method of producing nuclear magnetic resonance image data as claimed in claim 1 or 2, wherein the at least one time-varying magnetic field gradient applied to the target is sinusoidal.

4. A method of producing nuclear magnetic resonance image data as claimed in claim 3, wherein the step of applying at least one time-varying magnetic field gradient includes the steps of:

a. dividing the time duration of the step of applying into at least a preparation period, a data collection period and a post data collection period, wherein:

i. $t$ is time;

ii. $w_g$ is an angular frequency of the at least one time-varying magnetic field gradient;

iii. $T < t < 0$ is the preparation period, where $T = -3\pi/2w_g$;

iv. a first sub-period of the preparation period is when $-3\pi/2w_g < t < -\pi/2w_g$;

45

v.    a second sub-period of the preparation period is when $-\eta/2w_g < t < 0$;

vi.   the data collection period is when $0 < t < \gamma - \eta/2w_g$;

vii.  the post data collection period is when $\gamma - \eta/2w_g < t < \gamma$;

b. applying a magnetic field gradient, $(\underline{g}(t))_x$ wherein:

i.    $g_x$ is the maximum amplitude of the time-varying magnetic field gradient $(\underline{g}(t))_x$;

ii.   $(\underline{g}(t))_x = 0.5\ g_x \cos w_g t$, during the second sub-period of the preparation period;

iii.  $(\underline{g}(t))_x = g_x \cos w_g t$, during the second sub-period of the preparation period;

iv.   $(\underline{g}(t))_x = g_x$, during the data collection period;

v.    $(\underline{g}(t))_x = g_x \cos [w_g(t-\gamma+\eta/2w_g)]$, during the post data collection period;

c. applying magnetic field gradient $(\underline{g}(t))_y$ wherein:

i.    $g_y$ is the maximum amplitude of the magnetic field gradient $(\underline{g}(t))_y$;

ii.   $(\underline{g}(t))_y = 0.5\ g_y \cos w_g t$, during the first sub-period of the preparation period;

iii.  $(\underline{g}(t))_y = 0.5\ g_y \cos w_g t$, during the second sub-period of said preparation period, said data collection period, and the post data collection period.

5.    A method for producing nuclear resonance image data as claimed in claim 4, wherein the step of collecting data from the target is performed during the data collection period.

46

6.      A method for producing nuclear resonance image data as claimed in claim 4 or 5, wherein $w_c$ is the cut-off frequency of the resultant image, and wherein $\tau$ is defined such that:

$$X(\tau - \pi/2w_g) = \frac{\sqrt{2n\pi}\ g_x}{w_g} \geqslant w_c$$

with

$$\sqrt{g_y/w_g} \geqslant w_c$$

7.      A method for producing nuclear resonance image data as claimed in claim 6, wherein $\tau = (4n + k)\ \pi/2w_g$ and n is a positive integer and k is 1 or 3, thereby providing that g(t) maps a continuous path in Fourier space.

8.      A method of producing nuclear magnetic resonance image data which represents a characteristic of a target, comprising the steps of:

        a. exciting the target with a magnetic field and a radio frequency pulse;

        b. applying a first time-varying magnetic field gradient to the target;

        c. collecting first data from the target during the step of applying the first time-varying magnetic field gradient by acquiring a first data signal from the target, which is dependent in value on the values of a Fourier transform plus the spatial derivative of the Fourier transform of the said characteristic of the target at a plurality of sample points in a Fourier space occupied by the Fourier tranform;

d. determining the positions of the first data signal sample points on a first path in the Fourier space which first path is defined as a constant times the integral of the first time-varying gradient;

e. interpolating the value of the first data signals at a plurality of first Cartesian grid points in the Fourier space using the positions and values of the first data signal at the first data signal sample points in the Fourier space;

f. applying a second time-varying magnetic field gradient to the target, such that second data collected from the target during application of the second time-varying magnetic field gradient lie on a second path in the Fourier space, which second path starts at the end of the first path and is identical in shape and opposite in direction to the first path;

g. collecting the second data from the target during the step of applying the second time-varying magnetic field gradient by acquiring a second data signal from the target which second data signal is dependent in value upon the values of the Fourier transform minus the spatial derivative of the Fourier transform of the said characteristic of the target at a plurality of sample points on the second path;

h. determining the positions of the second data signal sample points on the second path;

48

i. interpolating the value of the second data signals at a plurality of second Cartesian grid points in the Fourier space using the said positions and values of the second data signal at the second data signal sample points in the Fourier space;

j. combining the interpolated values of the first and second data signals at corresponding first and second Cartesian grid points in the Fourier space to establish combined data for each of the Cartesian grid points; and

k. converting the values of the said interpolated and combined data at the Cartesian grid points in the Fourier space by Fourier transform to a spatial domain to produce said image data of said characteristic of the target.

9. A method of producing nuclear magnetic resonance image data which represents a characteristic of a target, comprising the step of:

a. exciting the target with a magnetic field and a radio frequency pulse;

b. applying a first time-varying magnetic field gradient to the target;

c. collecting first data from the target during the step of applying the first time-varying magnetic field gradient by acquiring a first data signal from the target, which is dependent in value on the values of a Fourier transform plus the spatial derivative of the Fourier transform of the said characteristic of the target at a plurality of sample points in a Fourier space occupied by the Fourier tranform;

d. determining the positions of the first data signal sample points on a first path in the Fourier space which first path is defined as a constant times the integral of the first time-varying gradient;

e. applying a second time-varying magnetic field gradient to the target, such that second data collected from the target during application of the second time-varying magnetic field gradient lie on a second path in the Fourier space, which second path starts at the end of the first path and is identical in shape and opposite in direction to the first path;

f. collecting the second data from the target during the step of applying the second time-varying magnetic field gradient by acquiring a second data signal from the target which second data signal is dependent in value upon the values of the Fourier transform minus the spatial derivative of the Fourier transform of the said characteristic of the target at a plurality of sample points on the second path;

g. determining the positions of the second data signal sample points on the second path;

h. combining the values of the first and second data signals at corresponding positions along the first and second paths to establish combined data for each of the said positions;

i. interpolating the value of the combined data at a plurality of second Cartesian grid points in the Fourier space; and

j. converting the values of the interpolated and combined

50

data at the Cartesian grid points in the Fourier space by Fourier transform to a spatial domain to produce the image data of the said characteristic of the target.

10.        A method of producing nuclear magnetic resonance data as claimed in claim 8 or 9, wherein the steps of collecting the first and second data respectively include the substeps of:

        a. receiving first and second magnetic signals from the target with a coil; and

        b. demodulating the first and second magnetic signals with at least one product detector and at least one low-pass filter to produce the first and second data signals.

11.        A method for producing nuclear magnetic resonance image data as claimed in claim 8 or 9, wherein the step of applying the first time-varying magnetic field gradient includes a preparatory phase wherein the first time-varying magnetic field gradient is structured to cause the first path in Fourier space to pass through the origin point in the Fourier space to pass through the origin point in the Fourier space at a preselected time and $g(t)$ is continuous for $t \in [T, 0+]$.

12.        A method of producing nuclear magnetic resonance image data as claimed in claim 11, wherein the step of applying the second time-varying magnetic field gradient includes a preliminary phase wherein the second time-varying magnetic field gradient is

51

structured to cause the second path in Fourier space to pass in the said opposite direction through the end point of the first path at a preselected time.

13.    A method of producing nuclear magnetic resonance image data as claimed in any one of claims 8 to 12, wherein the first and second time-varying magnetic field gradient applied to the target are sinusoidal.

14.    A method of producing nuclear magnetic resonance image data as claimed in any one of claims 8 to 13, wherein the step of applying the first time-varying magnetic field gradient includes the steps of:

a. dividing the time duration of the step of applying into at least a preparation period, a data collection period and a post data collection period, wherein:

i.    t is time;

ii.    $w_g$ is an angular frequency of the at least one time-varying magnetic field gradient;

iii. $T < t < 0$ is the preparation period, where $T = -3\pi/2w_g$;

iv.    a first sub-period of the preparation period is when $-3\pi/2w_g < t < -\pi/2w_g$;

v.    a second sub-period of the preparation period is when $-\pi/2w_g < t < 0$;

vi.    the data collection period is when $0 < t < \tau - \pi/2w_g$;

vii. the post data collection period is when $\tau - \pi/2w_g < t < \tau$;

52

b. applying a magnetic field gradient, $(g(t))_x$ wherein:

i. $g_x$ is the maximum amplitude of the time-varying magnetic field gradient $(g(t))_x$;

ii. $(g(t))_x = 0.5\ g_x \cos w_g t$, during the second sub-period of the preparation period;

iii. $(g(t))_x = g_x \cos w_g t$, during the second sub-period of the preparation period;

iv. $(g(t))_x = g_x$, during the data collection period;

v. $(g(t))_x = g_x \cos [w_g(t-\tilde{\gamma}+\tilde{\chi}/2w_g)]$, during the post data collection period;

c. applying magnetic field gradient $(g(t))_y$ wherein:

i. $g_y$ is the maximum amplitude of the magnetic field gradient $(g(t))_y$;

ii. $(g(t))_y = 0.5\ g_y \cos w_g t$, during the first sub-period of the preparation period;

iii. $(g(t))_y = 0.5\ g_y \cos w_g t$, during said second sub-period of said preparation period, said data collection period, and said post data collection period.

15.     A method of producing nuclear resonance image data as claimed in claim 14, wherein the step of collecting data from the target is performed during the data collection period.

16.     A method of producing nuclear resonance image data as claimed in claim 14, wherein the step of applying the first time-varying magnetic field gradient further includes the step of

53

traversing a sinusoidal path defined by a constant times the integral of the first time-varying gradient, wherein $w_c$ is the cut-off frequency of the resultant image, and wherein $\Upsilon$ is defined such that:

$$X(\Upsilon - \Upsilon/2w_g) = \underline{\partial 2n\Upsilon \cdot g_x} \geqslant w_c$$
$$w_g$$

with

$$\partial g_y/w_g \geqslant w_c$$

17. A method of producing nuclear magnetic resonance image data as claimed in claim 15, wherein $\Upsilon =(4n + k)\Upsilon/2w_g$, and n is a positive integer and k is 1 or 3, thereby providing that $\underline{g}(t)$ is continous.

18. A method as claimed in claim 14, 15 or 16 wherein the step of applying the second time-varying magnetic field gradient includes the substep of:

a. applying a time-varying magnetic field gradient $(\underline{g}(t))_x$ during the period $\Upsilon \leqslant t \leqslant 2\Upsilon$, where $(\underline{g}(t))_x = -(\underline{g}(2\Upsilon - t))_x$; and

b. applying a magnetic field gradient during the $(\underline{g}(t))_y$ period $\Upsilon \leqslant t \leqslant 2\Upsilon$, where $g_y(t)$ equals $-(\underline{g}(2\Upsilon - t))_y$.

19. A method as claimed in claim 18, including the further step of:

54

a. applying a third time-varying magnetic field during the time period $2\tau \leqslant t \leqslant 3\tau$, which has a time-varying gradient $(\underline{g}(t))_x = (\underline{g}(t - 2\tau))_x$, and a time-varying gradient $(\underline{g}(t))_y = (\underline{g}(t - 2\tau))_y$, and

b. applying a fourth time-varying magnetic field during the time period $3\tau \leqslant t \leqslant 4\tau$, which has a time-varying gradient $(\underline{g}(t))_x = (\underline{g}(4\tau - t))_x$, and a time-varying gradient $(\underline{g}(t))_y = (\underline{g}(4\tau - t))_y$.

FIG. 1.

FIG. 2(a).

FIG. 2(b).

MAGNITUDE OF B

$z \cdot g_z$ GRADIENT

$B_S$

$B_S + z \cdot g_z$

$B_S$

$T$

$0$

$t$

FIG. 3(a).

MAGNITUDE OF
R.F. MAG FIELD

TAILORED
R.F. PULSE

$T$

$0$

$t$

EXCITATION PERIOD

SUBSIQUENT PREPARATION
AND DATA COLLECTION STEPS

FIG. 3(b).

$y$

$1$

$z$

$10$

$n - \frac{1}{2}$

$n + \frac{1}{2}$

$12$

$12$

$12$

$12$

$16$

FIG. 5.

0151026

3/10

FIG. 4.

FIG. 6.

FIG. 7.

FIG. 9.

Fig.8.

6/10

Fig. 10.

Fig. 11.

Fig. 12.

0151026

0151026

Fig. 13.

Fig. 14.

Fig. 15.

Fig. 16.

FIG. 17.